# EUROPÄISCHE PATENTSCHRIFT

(11) **EP 1 317 061 B1**
(45) Veröffentlichungstag und Bekanntmachung des Hinweises auf die Patenterteilung: **30.11.2011**
(21) Anmeldenummer: 02022796.3
(22) Anmeldetag: 11.10.2002
(51) Int. Cl.: H03F 1/02

(54) **Bipolartransistor-Verstärkerschaltung**
Bipolar transistor amplifying circuit
Circuit amplificateur à transistor bipolaire

(30) Priorität: 30.11.2001 DE 10158799
(43) Veröffentlichungstag der Anmeldung: 04.06.2003
(73) Patentinhaber: Infineon Technologies AG, 85579 Neubiberg (DE)
(72) Erfinder: Jaeschke, Holger, 83139 Söchtenau (DE); Stolz, Dietmar, 81669 München (DE)
(74) Vertreter: Schoppe, Fritz

(56) Entgegenhaltungen:
- US-A- 3 519 765
- US-A- 4 028 629
- US-B1- 6 253 070

## Beschreibung

Die vorliegende Erfindung bezieht sich auf Bipolartransistor-Verstärkerschaltungen und insbesondere auf Bipolartransistor-Verstärkerschaltungen mit einem steuerbaren Gewinn.

Bipolartransistor-Verstärkerschaltungen werden bei zahlreichen Anwendungen eingesetzt. Sie weisen gewöhnlich zwei verschiedene Werte des Gewinns bzw. der Verstärkung auf, und zwar einen im ausgeschalteten Zustand bzw. Aus-Modus, in dem keine Leistungsversorgung der Schaltung stattfindet, und einen im eingeschalteten Zustand bzw. An-Modus, in dem die Schaltung mit Leistung versorgt wird. Im ausgeschalteten Zustand ist der Gewinn dabei in der Regel deutlich negativ, d. h. es liegt eine Einfügedämpfung vor.

Bei vielen Anwendungen, beispielsweise bei tragbaren bzw. mobilen Empfängern, deren Leistungsversorgung aus einer Batterie oder einem Akkumulator erfolgt, ist ein möglichst geringer Leistungsbedarf der Verstärkerschaltung wünschenswert. Andererseits wird beispielsweise eine Verstärkerschaltung am Eingang eines Empfangsteiles nur benötigt, wenn ein schwaches Signal empfangen wird. Dies ist jedoch typischerweise nur während eines Bruchteiles der Betriebszeit der Fall. In der übrigen Betriebszeit ist es wünschenswert, den Leistungsbedarf der Verstärkerschaltung zu reduzieren, indem ihre Verstärkung bzw. ihr Gewinn reduziert wird.

Eine Möglichkeit den Gewinn und den Leistungsbedarf der Verstärkerschaltung zu senken besteht darin, dieselbe auszuschalten, d. h. sie von der Leistungsversorgung zu trennen. Um die dadurch hervorgerufene deutliche Einfügedämpfung zu vermeiden, ist im Stand der Technik die Verwendung eines Bypass-Schalters zwischen Verstärkereingang und -ausgang bekannt. Alternativ werden Dioden am Verstärkereingang gegen Kleinsignal-Masse durchgeschaltet. Der Artikel "A 1,7 mA Low Noise Amplifier with Integrated Bypass Switch for Wireless 0,05-6 GHz Portable Applications" von H. Morkner et al. und der Artikel "A Wide Dynamic Range Switched-LNA In SIGE BICMOS" von T. Nakatani et al. beschreiben typische Verstärkerschaltungen mit Bypass-Schaltern.

Ein Nachteil dieser Verstärkerschaltungen besteht darin, daß zusätzliche Bauelemente benötigt werden. Dadurch wird nicht nur der Herstellungsaufwand erhöht, sondern auch die Leistung der Verstärkungsschaltung reduziert.

US 4028629 offenbart eine Schaltung bei der ein bipolarer Transistor mittels umgekehrter Versorgungsspannungen in einen inversen Betrieb geschaltet werden kann.

Die Aufgabe der vorliegenden Erfindung besteht darin, eine einfache Bipolartransistor-Verstärkerschaltung mit steuerbarem Gewinn bzw. ein einfaches Verfahren zur Steuerung des Gewinns einer Bipolartransistor-Verstärkerschaltung zu schaffen.

Diese Aufgabe wird durch eine Verstärkerschaltung nach Anspruch 1 gelöst.

Gemäß der vorliegenden Erfindung wird ein Gewinn einer Verstärkerschaltung mit einem Bipolartransistor verringert ohne eine starke Einfügedämpfung zu erzeugen, wenn mittels einer steuerbaren Leistungsversorgung die Polarität einer Spannung zwischen dem Emitteranschluß und dem Kollektoranschluß des Bipolartransistors umgekehrt werden kann. Wenn der Kollektorstrom umgekehrt wird, arbeitet der Bipolartransistor im "inversen Betrieb", in dem der Gewinn der Verstärkerschaltung einen Wert zwischen dem im ausgeschalteten und dem im eingeschalteten Zustand annimmt.

Ein Vorteil der vorliegenden Erfindung besteht darin, daß keine zusätzlichen Bauelemente in der Verstärkerschaltung benötigt werden. Dadurch wird einerseits der Herstellungsaufwand verringert und andererseits die Leistung der Verstärkungsschaltung verbessert. Ferner ist eine Verstärkung bzw. ein Gewinn im Bereich von 0 dB im Gegensatz zu deutlichen Einfügedämpfungen bei anderen Ansätzen gemäß dem Stand der Technik möglich.

Bevorzugte Weiterbildungen werden in den Unteransprüchen definiert.

Nachfolgend werden bevorzugte Ausführungsbeispiele der vorliegenden Erfindung mit Bezug auf die beiliegenden Figuren näher erläutert. Es zeigen:
- Fig. 1: eine schematische Darstellung eines ersten Beispieles einer Verstärkerschaltung;
- Fig. 2: eine schematische Darstellung eines zweiten Beispieles ;
- Fig. 3: eine schematische Darstellung eines ersten Ausfüh- rungsbeispieles der vorliegenden Erfindung;
- Fig. 4: eine schematische Darstellung eines zweiten Ausfüh- rungsbeispieles der vorliegenden Erfindung;
- Fig. 5: die Frequenzabhängigkeit des Gewinnes bei dem ersten Ausführungsbeispiel der vorliegenden Erfindung für die verschiedenen Betriebsmodi; und
- Fig. 6: die Frequenzabhängigkeit des Gewinnes bei dem zweiten Ausführungsbeispiel der vorliegenden Erfindung für die verschiedenen Betriebsmodi.

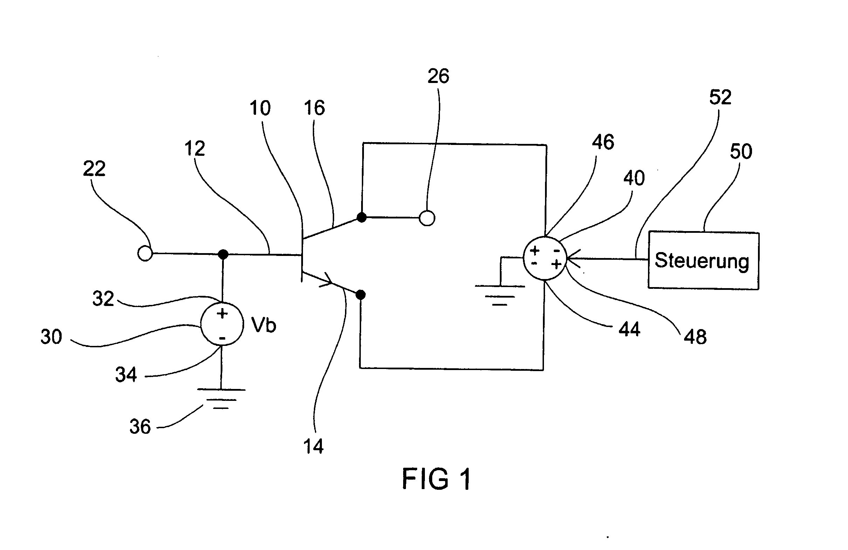

Fig. 1 ist eine schematische Darstellung einer Verstärkerschaltung. Die Verstärkerschaltung umfaßt einen npn-Bipolartransistor 10 mit einem Basisanschluß 12, einem Emitteranschluß 14 und einem Kollektoranschluß 16. Der Basisanschluß 12 ist mit einem Eingang 22 der Verstärkerschaltung verbunden, der Kollektoranschluß 16 ist mit einem Ausgang 26 der Verstärkerschaltung verbunden. Ferner umfaßt die Verstärkerschaltung eine Basisgleichspannungsquelle 30 mit einem ersten Anschluß 32, der mit dem Basisanschluß 12 und dem Eingang 22 verbunden ist, und einen zweiten Anschluß 34, der mit einem Bezugspotential 36, z. B. Masse, verbunden ist. Eine Leistungsversorgung 40 umfaßt einen ersten Anschluß 44, der mit dem Emitteranschluß 14 des Bipolartransistors 10 verbunden ist, einen zweiten Anschluß 46, der mit dem Kollektoranschluß 16 des Bipolartransistors 10 und dem Ausgang 26 verbunden ist, und einen Steuereingang 48 zum Empfangen einer Steuersignales. Ferner ist die Leistungsversorgung mit dem Bezugspotential 36 verbunden. Eine Steuerung 50 umfaßt einen Steuerausgang 52 zum Ausgeben eines Steuersignales, der mit dem Steuereingang 48 der Leistungsversorgung 40 verbunden ist.

Gemäß dem beschriebenen Beispiel erzeugt die Steuerung 50 das Steuersignal mit einem ersten Zustand und mit einem zweiten Zustand. In dem ersten Zustand bewirkt das Steuersignal, daß die Leistungsversorgung 40 eine Spannung mit einer ersten Polarität zwischen dem Kollektoranschluß 16 und dem Emitteranschluß 14 des Bipolartransistors 10 erzeugt. In dem zweiten Zustand bewirkt das Steuersignal, dass die Leistungsversorgung 40 eine Spannung mit einer zweiten Polarität, die der ersten Polarität entgegengesetzt ist, zwischen den Kollektoranschluß 16 und den Emitteranschluß 14 anlegt. Die durch die Leistungsversorgung 40 erzeugbaren Spannungen mit den zwei Polaritäten haben vorzugsweise den gleichen Betrag. Alternativ können die Beträge der erzeugten Spannungen auch unterschiedlich sein, um hierdurch für eine Steuerung des Gewinnes (Verstärkung) noch einen weiteren Freiheitsgrad zu gewinnen.

Wenn die von der Leistungsversorgung 40 zwischen dem Kollektoranschluß 16 und dem Emitteranschluß 14 des Bipolartransistors 10 angelegte Spannung positiv ist, wird der npn-Bipolartransistor 10 in einem On- bzw. An-Modus betrieben. In einer Vielzahl von herkömmlichen Schaltungen werden Bipolartransistoren in diesem An-Modus betrieben. Der An-Modus stellt somit einen "Normalbetrieb" dar. Im An-Modus sind die Basis-Emitter-Diode in Flußrichtung und die Kollektor-Basis-Diode in Sperrichtung gepolt, und der Bipolartransistor 10 weist einen hohen Gewinn auf, dessen Wert von dem Betrag der Spannung zwischen Kollektoranschluß 16 und Emitteranschluß 14 abhängt.

Wenn die Leistungsversorgung 40 abgeschaltet ist, und somit keine Spannung zwischen dem Kollektor 16 und dem Emitter 14 des Bipolartransistors 10 anliegt, befindet sich die Verstärkerschaltung in einem off- bzw. Aus-Modus. In diesem Modus weist die Verstärkerschaltung eine deutliche Einfügedämpfung zwischen dem Eingang 22 und dem Ausgang 26 auf. Wie bereits eingangs erwähnt, ist die Dämpfung in diesem Aus-Modus für viele Anwendungen zu groß.

Die Verstärkerschaltung bietet einen zusätzlichen Modus mit einem zusätzlichen Gewinnschritt bzw. Gainstep, wobei der Gewinn zwischen dem hohen (positiven) Gewinn im An-Modus und dem (negativen) Gewinn im Aus-Modus liegt. In diesem Gewinnschritt- bzw. Invers-Modus wird die Strom- bzw. Spannungsversorgung am Kollektoranschluß 16 und am Emitteranschluß 14 vertauscht bzw. umgekehrt. Dazu legt die Leistungsversorgung 40 gesteuert durch das Steuersignal von der Steuerung 50 eine Spannung mit einer gegenüber dem An-Modus umgekehrten Polarität zwischen dem Kollektoranschluß 16 und dem Emitteranschluß 14 an. Bei dieser negativen Spannung zwischen dem Kollektoranschluß 16 und dem Emitteranschluß 14 sind die Kollektor-Basis-Diode des npn-Bipolartransistors 10 in Flußrichtung, und die Basis-Emitter-Diode des npn-Bipolartransistors 10 in Sperrichtung gepolt. Der Bipolartransistor 10 befindet sich somit in einem Inversbetrieb, in dem sein Gewinn kleiner ist als im An-Modus, jedoch größer als im Aus-Modus.

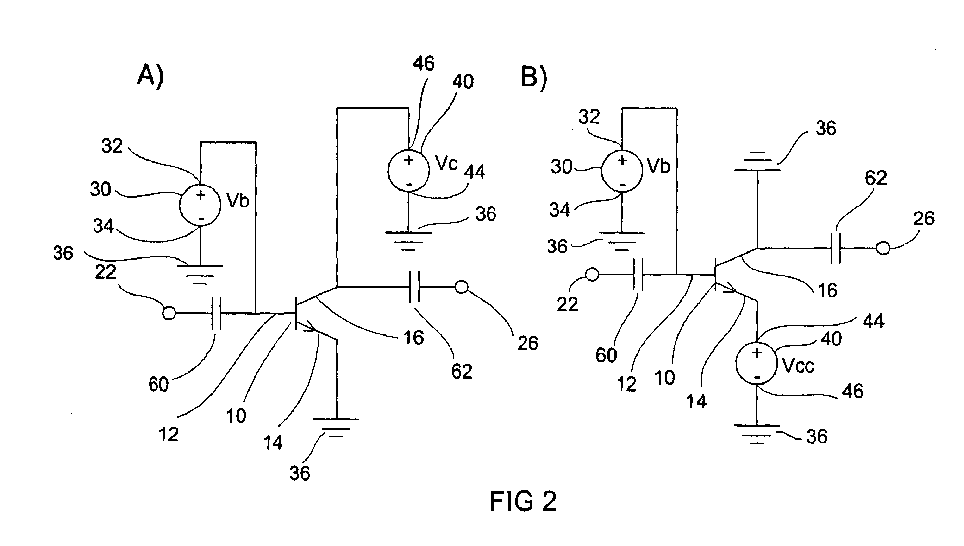

Der zusätzliche Betriebsmodus der Verstärkerschaltung kann beispielsweise bei Verwendung der Verstärkerschaltung am Eingang eines Empfängers einer Mobilfunkvorrichtung dazu verwendet werden, um im Fall eines starken Eingangssignales dieses nicht oder nicht wesentlich zu verstärken, jedoch auch nicht wesentlich zu dämpfen bevor es nachgeordneten Schaltungen zugeführt wird. Die Steuerung 50 kann in diesem Beispiel eine Einrichtung zum Bestimmen des Eingangssignalpegels umfassen, wobei die Steuerung den An-Modus steuert, wenn der Eingangssignalpegel unter einem vorbestimmten Schwellwert liegt, und den Invers-Modus steuert, wenn der Eingangssignalpegel über dem vorbestimmten Schwellwert liegt. Fig. 2 ist eine schematische Darstellung eines zweiten Beispieles der einer Verstärkerschaltung, wobei Fig. 2A die Schaltung in dem oben beschriebenen An-Modus und Fig. 2B die Schaltung in dem oben beschriebenen Invers-Modus zeigt. Die Verstärkerschaltung umfaßt wiederum einen npn-Bipolartransistor 10 mit einem Basisanschluß 12, einem Emitteranschluß 14 und einem Kollektoranschluß 16 und eine Basisgleichspannungsquelle 30. Ein erster Anschluß 32 der Basisgleichspannungsquelle 30 ist mit dem Basisanschluß 12 des Bipolartransistors 10 verbunden, und ein zweiter Anschluß 34 der Basisgleichspannungsquelle 30 ist mit Masse 36 verbunden. Der Basisanschluß 12 des Bipolartransistors 10 ist über einen ersten Kondensator 60 zur Gleichspannungsentkopplung mit einem Eingang 22 der Verstärkerschaltung verbunden, und der Kollektoranschluß 16 des Bipolartransistors 10 ist über einen zweiten Kondensator 62 zur Gleichspannungsentkopplung mit einem Ausgang 26 der Verstärkerschaltung verbunden.

Fig. 2A und 2B zeigen schematisch, wie die Leistungsversorgung 40 in den zwei Betriebsmodi der erfindungsgemäßen Verstärkerschaltung zwischen die Transistoranschlüsse 14, 16 und Masse 36 geschaltet ist.

In dem in Fig. 2A dargestellten An-Modus ist die Leistungsversorgung 40 zwischen den Kollektoranschluß 16 und Masse 36 geschaltet, um eine Spannung Vc zwischen dem Kollektoranschluß 16 des Bipolartransistors 10 und Masse 36 anzulegen, wobei der Emitteranschluß 14 des Bipolartransistors 10 mit Masse 36 verbunden ist. Dazu sind der erste Anschluß 44 der Leistungsversorgung 40 sowie der Emitteranschluß 14 des Bipolartransistors 10 mit Masse 36 verbunden und der zweite Anschluß 46 der Leistungsversorgung 40 mit dem Kollektoranschluß 16 des Bipolartransistors 10 verbunden.

In Fig. 2B ist die Verstärkerschaltung im Invers-Modus dargestellt, in dem die Leistungsversorgung 40 zwischen den Emitteranschluß 14 und Masse 36 geschaltet ist, um eine Spannung Vcc zwischen den Emitteranschluß 14 und Masse 36 anzulegen, wobei der Kollektoranschluß 16 auf Massepotential liegt. Dazu sind der erste Anschluß 44 der Leistungsversorgung 40 mit dem Emitteranschluß 14 des Bipolartransistors 10 verbunden und der zweite Anschluß 46 der Leistungsversorgung 40 und der Kollektoranschluß 16 des Bipolartransistors 10 mit der Masse 36 verbunden.

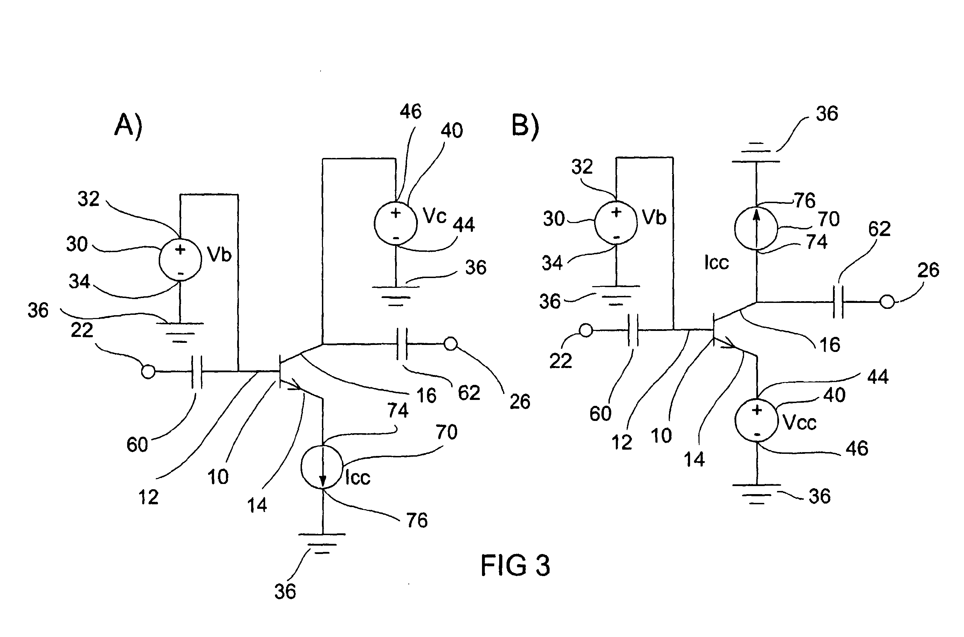

Fig. 3 ist eine schematische Darstellung eines ersten Ausführungsbeispieles einer Verstärkerschaltung gemäß der vorliegenden Erfindung. Die in Fig. 3 dargestellte Verstärkerschaltung unterscheidet sich von der in Fig. 2 dargestellten nur dadurch, daß zusätzlich eine Stromsenke 70 vorgesehen ist, die hier als eigenständiges Bauelement dargestellt ist, jedoch auch als Bestandteil der Leistungsversorgung 40 angesehen werden kann. Die Stromsenke 70 dient dazu, den Versorgungsstrom über den Emitteranschluß 14 und den Kollektoranschluß 16 in beiden Betriebsmodi konstant zu halten.

In dem in Fig. 3A dargestellten An-Modus ist die Stromsenke 70 zwischen den Emitteranschluß 14 und Masse 36 geschaltet, wobei in dem in Fig. 3B dargestellten Invers-Modus die Stromsenke zwischen den Kollektoranschluß 16 und Masse 36 geschaltet ist.

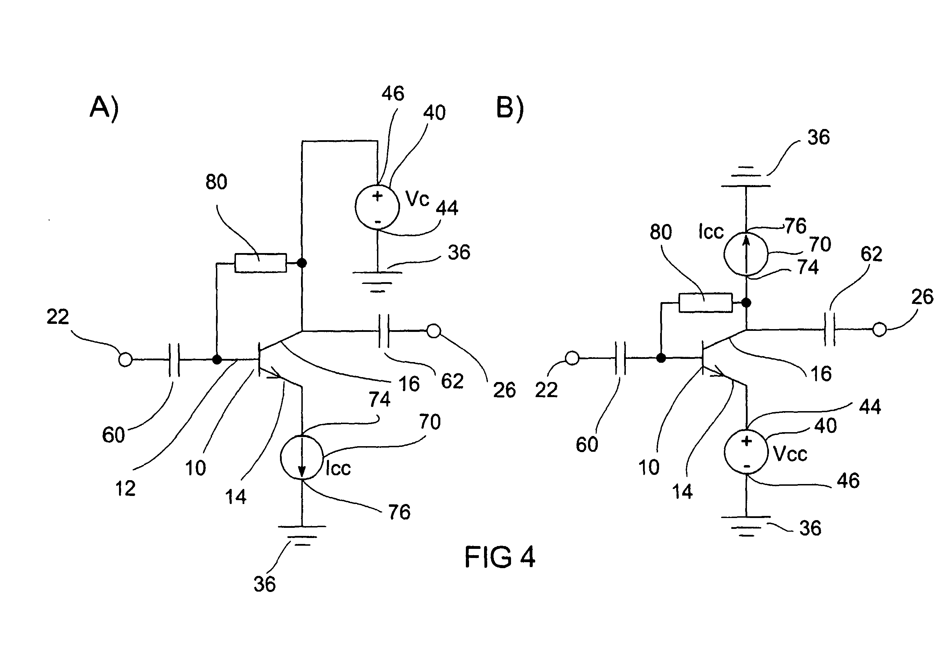

Fig. 4 ist eine schematische Darstellung eines zweiten Ausführungsbeispieles der Verstärkerschaltung gemäß der vorliegenden Erfindung. Die in Fig. 4 dargestellte Verstärkerschaltung unterscheidet sich von der in Fig. 3 dargestellten dadurch, daß sie keine Basisgleichstromquelle 30 aufweist, sondern der Basisanschluß 12 des Bipolartransistors 10 über einen Widerstand 80 mit dem Kollektoranschluß 16 des Bipolartransistors 10 verbunden ist. Die Beschaltungen des Emitteranschlusses 14 und des Kollektoranschlusses 16 mit der Leistungsversorgung 40 und der Stromsenke 70 im An-Modus und im Invers-Modus unterscheiden sich nicht von denen der in Fig. 3 dargestellten Verstärkerschaltung.

Bei den in den Fig. 1 bis 4 dargestellten Beispielen bzw. Ausführungsbeispielen können die Spannung Vc und Vcc, die im An-Modus und im Invers-Modus mit unterschiedlichem Vorzeichen bzw. unterschiedlicher Polarität zwischen dem Kollektoranschluß 16 und dem Emitteranschluß 14 des Bipolartransistors 10 angelegt werden, den gleichen oder unterschiedliche Beträge aufweisen. Dadurch ist eine Einstellung des Gewinns in beiden Modi unabhängig voneinander möglich. Die Änderung der Polarität der zwischen dem Kollektoranschluß 16 und dem Emitteranschluß 14 des Bipolartransistors 10 angelegten Spannung kann erfolgen, indem die Anschlüsse 44, 46 der Leistungsversorgung 40 und gegebenenfalls die Anschlüsse 74, 76 der Stromsenke 70 in zwei verschiedenen Kombinationen mit dem Emitteranschluß, dem Kollektoranschluß 16 und der Masse 36 verschaltet werden. Dies kann beispielsweise mittels einer entsprechenden Anzahl von Schaltern geschehen. Alternativ kann die Leistungsversorgung 40 ungeschaltet mit Emitteranschluß 14 und Kollektoranschluß 16 des Bipolartransistors 10 verbunden sein, wobei die Polarität der von der Leistungsversorgung 40 erzeugte Spannung intern umgekehrt werden kann. Diese Alternative entspricht den in den Fig. 2 bis 4 dargestellten Beschaltungen, wobei bei diesen zusätzlich jeweils der Anschluß 44, 46 der Leistungsversorgung 40 mit dem niedrigeren elektrostatischen Potential mit Masse verbunden ist. Die Stromsenke 70 kann, wie es in den Fig. 3 und 4 angedeutet ist, eine von der Leistungsversorgung 40 getrennte und unabhängige Baugruppe sein. Alternativ können die Leistungsversorgung 40 und die Stromsenke 70 in einer gemeinsamen Baugruppe integriert sein.

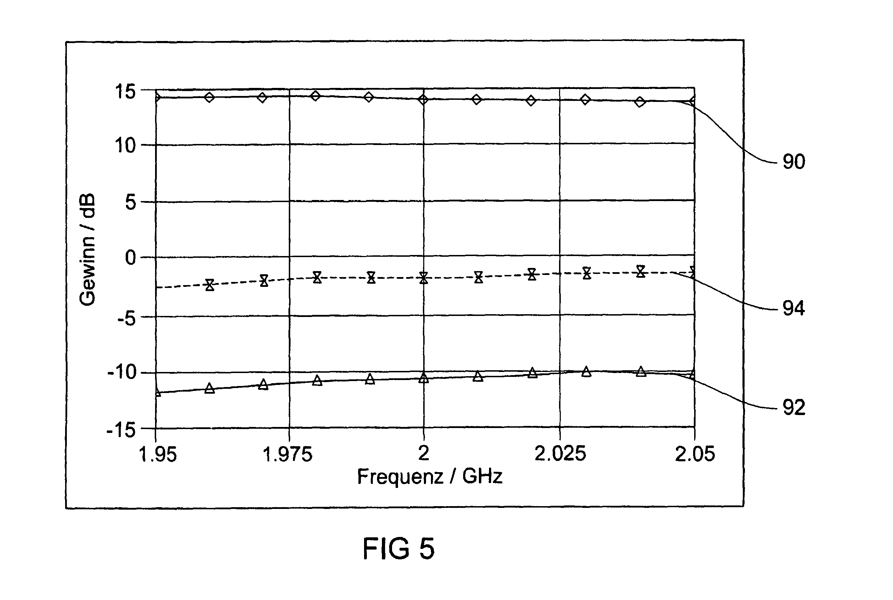

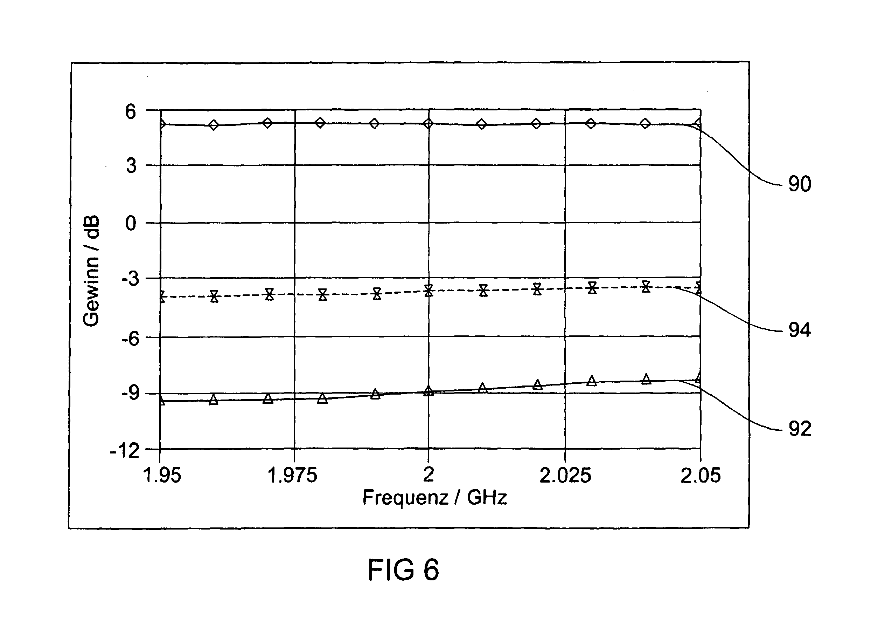

Die Fig. 5 und 6 zeigen schematische Darstellungen von Ergebnissen von Messungen der Frequenzabhängigkeit des Gewinns an zwei verschiedenen Verstärkerschaltungen gemäß der vorliegenden Erfindung, bei denen verschiedene Bipolartransistoren zum Einsatz kamen. An der Abszisse ist jeweils die Frequenz in 90 sind jeweils dem An-Modus zugeordnet, die Kurven 92 dem Aus-Modus und die Kurven 94 dem Invers-Modus.

In den Fig. 5 und 6 ist zu erkennen, daß die Gewinne in allen drei Modi im dargestellten Frequenzintervall von der Frequenz nur schwach abhängig sind, und daß im gesamten dargestellten Frequenzintervall der Gewinn im Invers-Modus Werte zwischen dem Gewinn im An-Modus und dem Gewinn im Aus-Modus annimmt.

Bei den oben dargestellten Ausführungsbeispielen ist der Bipolartransistor 10 ein npn-Bipolartransistor 10. Statt dessen ist die erfindungsgemäße Verstärkerschaltung jedoch auch mit einem pnp-Bipolartransistor realisierbar, wenn sämtliche Spannungen und Stromrichtungen in der Verstärkerschaltung umgekehrt werden.

Die erfindungsgemäße gesteuerte Versorgung eines Bipolartransistors mit Versorgungsspannungen mit zwei verschiedenen Polaritäten ist nicht auf die dargestellten Schaltungen beschränkt sondern auf alle Verstärkerschaltungen anwendbar.

Anstelle der Verwendung einer Spannungsquelle zur Versorgung der Basis des Transistors kann bei anderen Ausführungsbeispielen auch eine Stromquelle verwendet werden.

### Bezugszeichenliste

- 10: npn-Bipolartransistor
- 12: Basisanschluß
- 14: Emitteranschluß
- 16: Kollektoranschluß
- 22: Eingang
- 26: Ausgang
- 30: Basisgleichspannungsquelle
- 32: erster Anschluß
- 34: zweiter Anschluß
- 36: Bezugspotential
- 40: Leistungsversorgung
- 44: erster Anschluß
- 46: zweiter Anschluß
- 48: Steuereingang
- 50: Steuerung
- 52: Steuerausgang
- 60: erster Kondensator
- 62: zweiter Kondensator
- 70: Stromsenke
- 80: Widerstand
- 90,: 92, 94 Kurve

## Patentansprüche

1. Verstärkerschaltung mit folgenden Merkmalen:
einem Bipolartransistor (10) mit einem Basisanschluss (12), einem Emitteranschluss (14) und einem Kollektoranschluss (16);
einer Leistungsversorgung (40) zum Erzeugen einer Spannung (Vc) mit einer ersten Polarität oder einer Spannung (Vcc) mit einer zweiten Polarität, die der ersten Polarität entgegengesetzt ist, zwischen dem Emitteranschluss (14) und dem Kollektoranschluss (16), abhängig von einem Steuersignal; und
einer Stromsenke (70), die abhängig von dem Steuersignal zwischen den Kollektoranschluss (16) und das Bezugspotential (36) oder zwischen den Emitteranschluss (14) und das Bezugspotential (36) geschaltet ist, wobei die Stromsenke (70) ausgelegt ist, um einen Versorgungsstrom über den Emitteranschluss (14) und den Kollektoranschluss (16) in beiden Betriebsmodi konstant zu halten.

2. Verstärkerschaltung nach Anspruch 1, ferner mit einer Steuerung (50), die mit der Leistungsversorgung (40) verbunden ist, zum Erzeugen des Steuersignales, wobei das Steuersignal einen ersten Zustand aufweist, um die Leistungsversorgung (40) derart zu steuern, dass zwischen dem Kollektoranschluss (16) und dem Emitteranschluss (14) die Spannung mit der ersten Polarität anliegt, und wobei das Steuersignal einen zweiten Zustand aufweist, um die Leistungsversorgung derart zu steuern, dass zwischen dem Kollektoranschluss (16) und dem Emitteranschluss (14) die Spannung mit der zweiten Polarität anliegt.

3. Verstärkerschaltung nach Anspruch 1 oder 2, ferner mit einer Basisgleichspannungsquelle (30) zum Anlegen einer Gleichspannung zwischen den Basisanschluss (12) und das Bezugspotential (36).

4. Verstärkerschaltung nach einem der Ansprüche 1 bis 3, ferner mit einem Widerstand (80), der zwischen den Basisanschluss (12) und den Kollektoranschluss (16) geschaltet ist.

5. Verstärkerschaltung nach einem der Ansprüche 1 bis 4, ferner mit:
einem Eingang (22), der mit dem Basisanschluss (12) verbunden ist; und
einem Ausgang (26), der mit dem Kollektoranschluss (16) verbunden ist.

6. Verstärkerschaltung nach Anspruch 5, ferner mit:
einem ersten Kondensator (60), der zwischen den Eingang (22) und den Basisanschluss (12) geschaltet ist; und
einem zweiten Kondensator (62), der zwischen den Kollektoranschluss (16) und den Ausgang (26) geschaltet ist.

## Claims

1. Amplifier circuit, comprising:
a bipolar transistor (10) having a base terminal (12), an emitter terminal (14) and a collector terminal (16);
a power supply (40) for generating a voltage (Vc) with a first polarity or a voltage (Vcc) with a second polarity opposite to the first polarity between the emitter terminal (14) and the collector terminal (16), depending on a control signal; and
a current sink (70) connected between the collector terminal (16) and the reference potential (36) or between the emitter terminal (14) and the reference potential (36), depending on the control signal, wherein the current sink (70) is implemented to keep a supply current constant across the emitter terminal (14) and the collector terminal (16) in both operation modes.

2. Amplifier circuit according to claim 1, further comprising a control (50) connected to the power supply (40) for generating the control signal, wherein the control signal comprises a first state to control the power supply (40) such that the voltage with the first polarity is applied between the collector terminal (16) and the emitter terminal (14), and wherein the control signal comprises a second state to control the power supply such that the voltage with the second polarity is applied between the collector terminal (16) and the emitter terminal (14).

3. Amplifier circuit according to claims 1 or 2, further comprising a base direct voltage source (30) for applying a direct voltage between the base terminal (12) and the reference potential (36).

4. Amplifier circuit according to one of claims 1 to 3, further comprising a resistor (80) connected between the base terminal (12) and the collector terminal (16).

5. Amplifier circuit according to one of claims 1 to 4, further comprising:
an input (22) connected to the base terminal (12); and
an output (26) connected to the collector terminal (16).

6. Amplifier circuit according to claim 5, further comprising:
a first capacitor (60) connected between the input (22) and the base terminal (12); and
a second capacitor (62) connected between the collector terminal (16) and the output (26).

## Revendications

1. Circuit amplificateur, aux caractéristiques suivantes:
un transistor bipolaire (10) avec un raccordement de base (12), un raccordement d'émetteur (14) et un raccordement de collecteur (16);
une alimentation de puissance (40) destinée à générer une tension (Vc) avec une première polarité ou une tension (Vcc) avec une deuxième polarité qui est opposée à la première polarité, entre le raccordement d'émetteur (14) et le raccordement de collecteur (16), en fonction d'un signal de commande; et
un récepteur de courant (70) qui est connecté en fonction du signal de commande entre le raccordement de collecteur (16) et le potentiel de référence (36) ou entre le raccordement d'émetteur (14) et le potentiel de référence (36), le récepteur de courant (70) étant conçu pour maintenir un courant d'alimentation passant par le raccordement d'émetteur (14) et par le raccordement de collecteur (16) constant dans les deux modes de fonctionnement.

2. Circuit amplificateur selon la revendication 1, par ailleurs avec une commande (50) qui est reliée à l'alimentation de puissance (40), destinée à générer le signal de commande, le signal de commande présentant un premier état pour commander l'alimentation de puissance (40) de sorte qu'entre le raccordement de collecteur (16) et le raccordement d'émetteur (14) soit présente la tension avec la première polarité, et le signal de commande présentant un deuxième état pour commander l'alimentation de puissance (40) de sorte qu'entre le raccordement de collecteur (16) et le raccordement d'émetteur (14) soit présente la tension avec la deuxième polarité.

3. Circuit amplificateur selon les revendications 1 ou 2, par ailleurs avec une source de tension continue de base (30) destinée à appliquer une tension continue entre le raccordement de base (12) et le potentiel de référence (36).

4. Circuit amplificateur selon l'une des revendications 1 à 3, par ailleurs avec une résistance (80) qui est connectée entre le raccordement de base (12) et le raccordement de collecteur (16).

5. Circuit amplificateur selon l'une des revendications 1 à 4, par ailleurs avec:
une entrée (22) qui est reliée au raccordement de base (12); et
une sortie (26) qui est reliée au raccordement de collecteur (16).

6. Circuit amplificateur selon la revendication 5, par ailleurs avec:
un premier condenseur (60) qui est connecté entre l'entrée (22) et le raccordement de base (12); et
un deuxième condenseur (62) qui est connecté entre le raccordement de collecteur (16) et la sortie (26).
